# EUROPEAN PATENT SPECIFICATION

(11) **EP 1 862 519 B1**
(45) Date of publication and mention of the grant of the patent: **24.11.2010**
(21) Application number: 07010805.5
(22) Date of filing: 31.05.2007
(51) Int. Cl.: C09J 7/02

(54) **Pressure-sensitive adhesive sheet for dicing**
PSA-Folie zum Zerschneiden
Feuille adhésive sensible à la pression pour découpe

(30) Priority: 02.06.2006 JP 2006154736
(43) Date of publication of application: 05.12.2007
(73) Proprietor: NITTO DENKO CORPORATION, Osaka (JP)
(72) Inventor: Yamamoto, Shouji, Ibaraki-shi Osaka (JP)
(74) Representative: Grünecker, Kinkeldey, Stockmair & Schwanhäusser Anwaltssozietät

(56) References cited:
- EP-A- 0 447 855
- US-A- 4 343 856

## Description

### FIELD OF THE INVENTION

The present invention relates to a pressure-sensitive adhesive sheet for dicing, a method of processing a processed material using the same, and a piece of a processed material which can be obtained by the use of the method. The pressure-sensitive adhesive sheet for dicing according to the invention can be very suitably used as a pressure-sensitive adhesive sheet for dicing of, for example, a silicon semiconductor, a compound semiconductor, a semiconductor package, or a glass.

### BACKGROUND OF THE INVENTION

Conventionally, a semiconductor wafer made of silicon, gallium, arsenic, or the like has been manufactured to have a large diameter, cut and separated (diced) into small element pieces, and then subjected to a mounting process. At that time, the semiconductor wafer was subjected to a variety of steps such as a dicing step, a cleaning step, an expanding step, a pickup step, and a mounting step in a state where a pressure-sensitive adhesive sheet for dicing (hereinafter, referred to as "pressure-sensitive adhesive sheet") is attached to the semiconductor wafer. A pressure-sensitive adhesive sheet in which an acryl adhesive or the like is applied onto a substrate formed of a plastic film to form a pressure-sensitive adhesive layer with a thickness of 1 to 200 µm has been usually used as the pressure-sensitive adhesive sheet.

In the dicing step, the semiconductor wafer is diced by a round cutting edge moving while rotating to form semiconductor chips. In this step, a cutting method using a so-called full cut, in which the cutting edge is inserted into the inside of the substrate of the pressure-sensitive adhesive sheet holding the semiconductor wafer, has been mainly used.

In the cutting method using a full cut, a processed material is completely cut on the pressure-sensitive adhesive sheet and separated. Accordingly, in the conventional pressure-sensitive adhesive sheet, when the adhesive strength of the adhesive is too small, diced pieces may be scattered. On the contrary, when the adhesive strength is too large, it is difficult to pick up the diced pieces. Therefore, the pressure-sensitive adhesive sheet is required to have an appropriate magnitude of adhesive strength. From this point of view, an adhesive containing poly(meth)acrylic acid ester as a primary component, which has an adhesive characteristic with a wide control range and which can be easily manufactured, has been usually used.

In the subsequent expanding step, the pressure-sensitive adhesive sheet is required to have excellent expansibility. Accordingly, a pressure-sensitive adhesive sheet having excellent expansibility in which a polyvinyl chloride film is used as a substrate has been widely used. However, in the pressure-sensitive adhesive sheet using polyvinyl chloride for the substrate and using poly(meth)acrylic acid ester for the pressure-sensitive adhesive layer, there occurs a phenomenon that components such as additives contained in the substrate are transferred to the pressure-sensitive adhesive layer and thus the adhesive strength is deteriorated during the storage thereof. As a result, there is a problem with a scattering of chips during the dicing and a marked decrease in workability and yield.

In order to solve the above-mentioned problem, there has been disclosed a pressure-sensitive adhesive sheet for dicing in which a barrier layer made of various polymer materials is disposed between the substrate and the pressure-sensitive adhesive layer (for example, see Patent Documents 1 to 5). The barrier layer used in this pressure-sensitive adhesive sheet is provided between the substrate formed of a polyvinyl chloride film and the pressure-sensitive adhesive layer and has a function of preventing various additives in the polyvinyl chloride film from being transferred into the pressure-sensitive adhesive layer.

However, depending upon kinds of the barrier layer, although it may be possible to prevent a plasticizer as a kind of additive from being transferred, it may not be possible to sufficiently affect other additives in some cases. Furthermore, in some cases, although the barrier layer has a sufficient function as the barrier layer, the pressure-sensitive adhesive sheet is damaged in flexibility due to the barrier layer, thereby canceling the advantage resulting from the use of the polyvinyl chloride film as the substrate. Moreover, there is also such a problem that it is necessary to form the barrier layer in advance on the substrate before forming the pressure-sensitive adhesive layer and the addition of the forming step thus increases the manufacturing cost.
Patent Document 1 : JP-B-1-56111
Patent Document 2 : JP-A-4-192542
Patent Document 3 : JP-A-6-134941
Patent Document 4 : JP-A-8-112304
Patent Document 5 : JP-A-2002-235055

### SUMMARY OF THE INVENTION

The invention has been achieved to solve the above-mentioned problems. An object of the invention is to provide a pressure-sensitive adhesive sheet for dicing which can enhance long-term storage stability of an adhesive strength and can exhibit excellent flexibility in an expanding process by preventing a variety of additives contained in a substrate containing polyvinyl chloride as a primary component from being transferred to a pressure-sensitive adhesive layer; a method of processing a processed material using the same; and a piece of a processed material obtainable by the method.

### BRIEF DESCRIPTION OF THE DRAWINGS

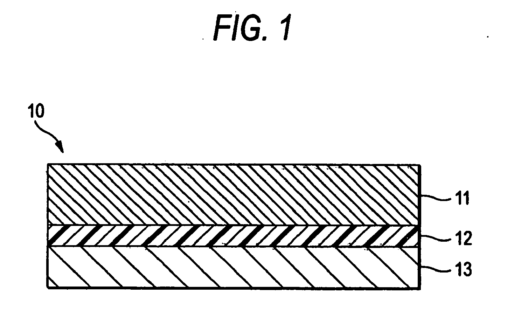

Fig. 1 is a sectional view schematically illustrating a pressure-sensitive adhesive sheet for dicing (hereinafter, referred to as a pressure-sensitive adhesive sheet) according to an embodiment of the invention.

### Description of the Reference Numerals and Signs

10: PRESSURE-SENSITIVE ADHESIVE SHEET
11: BASE FILM (SUBSTRATE)
12: PRESSURE-SENSITIVE ADHESIVE LAYER
13: SEPARATOR

### DETAILED DESCRIPTION OF THE INVENTION

The inventor of the present invention has made intensive studies on a pressure-sensitive adhesive sheet for dicing, a method of processing a processed material using the same, and a piece of a processed material obtainable by the method. As a result, the inventor found that a specific additive contained in the polyvinyl chloride affects the long-term storage stability of the adhesive strength of the pressure-sensitive adhesive sheet for dicing, thereby completing the invention.

Namely, the present invention relates to the following (1) to (5).
(1) A pressure-sensitive adhesive sheet for dicing, which comprises a substrate and at least one pressure-sensitive adhesive layer disposed on at least one surface of the substrate,
   said substrate containing polyvinyl chloride as a primary component and a trialkyl phosphite as a thermal stabilizer of the polyvinyl chloride, and
   said pressure-sensitive adhesive layer containing poly(meth)acrylic acid ester as a primary component, wherein the trialkyl phosphite transferred from the substrate into the pressure-sensitive adhesive layer is not unevenly distributed on a surface of the pressure-sensitive adhesive layer.
(2) The pressure-sensitive adhesive sheet according to (1) above, wherein the trialkyl phosphite is contained in an amount of from 0.2 to 1 parts by weight with respect to 100 parts by weight of the polyvinyl chloride.
(3) The pressure-sensitive adhesive sheet according to (1) above, wherein the trialkyl phosphite is a compound represented by the following chemical structural formula: 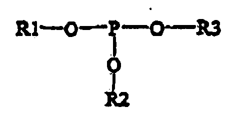 wherein R1, R2, and R3 are the same or different and each represent an alkyl group having 8 to 13 carbon atoms.
(4) The pressure-sensitive adhesive sheet according to (1) above, wherein the substrate has a thickness of from 50 to 200 µm and the pressure-sensitive adhesive layer has a thickness of from 5 to 20 µm.
(5) The pressure-sensitive adhesive sheet according to (1) above, which further comprises, as a thermal stabilizer of the polyvinyl chloride, an alkylaryl phosphite in an amount of less than 0.2 parts by weight with respect to 100 parts by weight of the polyvinyl chloride.
   The polyvinyl chloride film is formed by a calendar roll shaping method with an application of heat which can sufficiently soften a vinyl chloride resin. On the other hand, the vinyl chloride resin is decomposed by the heat, thereby generating toxic gas such as chlorine gas in some cases. Accordingly, the generation of the toxic gas is prevented by adding a thermal stabilizer in the course of shaping the polyvinyl chloride film. A phosphite (phosphite compound) stabilizer is used as a mandatory additive for the thermal stabilizer. Examples of the phosphite stabilizer include alkylaryl phosphites such as monoalkyl-diaryl phosphite and dialkyl-monoaryl phosphite. The alkylaryl phosphite is more widely used than trialkyl phosphite, because the alkylaryl phosphite has an excellent activity as the thermal stabilizer and a high thermal resistance. This is because the alkylaryl phosphite has fairly both of an alkyl group and an aryl group. That is, when the alkyl group is contained a lot, the activity as the thermal stabilizer is enhanced but the thermal resistance is deteriorated. When the aryl group is contained a lot, the thermal resistance as phosphite is enhanced but the activity as the thermal stabilizer is deteriorated.
   Trialkyl phosphite added to the substrate in the invention has been revealed to have an effect as the thermal stabilizer, but is a compound which has not been frequently used conventionally. This is because, as described above, the trialkyl phosphite has a poor thermal resistance and thus requires an addition of a thermal stabilizer in consideration of a thermally decomposed amount thereof in the course of manufacturing the polyvinyl chloride and because the design thereof is complex.
   However, the inventor has studied the deterioration in adhesive strength due to the alkylaryl phosphite, and thus found that when the alkylaryl phosphite is transferred into the pressure-sensitive adhesive layer, the alkylaryl phosphite is unevenly distributed in the vicinity of the surface of the pressure-sensitive adhesive layer and thus markedly reduces the adhesive characteristic during the storage of the pressure-sensitive adhesive sheet for dicing (hereinafter, referred to as a pressure-sensitive adhesive sheet). This is because, when an aryl group exists in a molecular structure like the alkylaryl phosphite, the compatibility with poly(meth)acrylic acid ester is reduced and thus even a small amount of alkylaryl phosphite transferred greatly affects the adhesive characteristic.
   On the other hand, since the trialkyl phosphite used in the invention does not contain aryl group, it is compatible with the poly(meth)acrylic acid ester. As a result, even when a small amount of thermal stabilizer is transferred into the pressure-sensitive adhesive layer, the trialkyl phosphite diffuses into the pressure-sensitive adhesive layer but does not unevenly distribute in the vicinity of the surface thereof. Therefore, it is possible to suppress the marked deterioration in adhesive strength even when the pressure-sensitive adhesive is stored for a long period of time.
   It is preferable that the content of the trialkyl phosphite with respect to 100 parts by weight of the polyvinyl chloride is in a range of from 0.2 to 1 parts by weight. When the content of the trialkyl phosphite is too large, although the uneven distribution of the trialkyl phosphite transferred into the pressure-sensitive adhesive layer in the vicinity of the surface of the pressure-sensitive adhesive layer can be prevented, a large amount of trialkyl phosphite is contained in the whole pressure-sensitive adhesive layer, thereby deteriorating the long-term storage stability of the pressure-sensitive adhesive layer. However, when the content is in the above-mentioned range, it is possible not only to prevent the trialkyl phosphite from being excessively transferred into the pressure-sensitive adhesive layer but also to further prevent the deterioration in the long-term storage stability of the pressure-sensitive adhesive layer. In addition, it is possible to greatly reduce the amount of polyvinyl chloride thermally decomposed during shaping the substrate.
   It is preferable that the trialkyl phosphite is a compound represented by the following chemical structural formula: 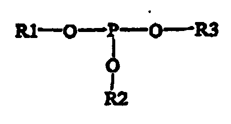 wherein R1, R2, and R3 are the same or different and each represent an alkyl group having 8 to 13 carbon atoms.
   When the content of the trialkyl phosphite is in the above-mentioned range, it is preferable that the thickness of the substrate is in a range of from 50 to 200 µm and the thickness of the pressure-sensitive adhesive layer is in a range of from 5 to 20 µm. The trialkyl phosphite diffuses into the pressure-sensitive adhesive layer so that it does not unevenly distribute in the vicinity of the surface of the pressure-sensitive adhesive layer but uniformly locates in the pressure-sensitive adhesive layer. Additionally, the trialkyl phosphite diffuses to be uniform in concentrations in the substrate and the pressure-sensitive adhesive layer. Accordingly, for example, in the case that the substrate and the pressure-sensitive adhesive layer have substantially the same thickness, the concentration of the trialkyl phosphite remaining in the substrate is reduced to the half as a result of the diffusion of the trialkyl phosphite into the pressure-sensitive adhesive layer. However, even in such a case, when the concentration of the remaining trialkyl phosphite is initially high and the trialkyl phosphite diffuses into the pressure-sensitive adhesive layer, it is not possible to expect a great decrease in concentration. However, since the diffusion of the trialkyl phosphite into the pressure-sensitive adhesive layer can be suppressed to the maximum by setting the thicknesses of the substrate and the pressure-sensitive adhesive layer to the above-mentioned ranges, it is possible to further prevent the deterioration in the long-term storage stability of the pressure-sensitive adhesive layer.
   It is preferable that alkylaryl phosphite is further contained as a thermal stabilizer of the polyvinyl chloride, in an amount of less than 0.2 parts by weight with respect to 100 parts by weight of the polyvinyl chloride. By adding the alkylaryl phosphite, it is possible to enhance the stability of the trialkyl phosphite as the thermal stabilizer in the course of shaping the substrate. It is for the following reason that the content of the alkylaryl phosphite is set to less than 0.2 parts by weight with respect to 100 parts by weight of the polyvinyl chloride. That is, the reason is to greatly suppress the alkylaryl phosphite from being transferred into the pressure-sensitive adhesive layer and being unevenly distributed in the vicinity of the surface thereof to thereby prevent the deterioration in adhesive strength.
   Furthermore, the present invention relates to the following (6) and (7).
(6) A method of processing a processed material, which comprises:
   attaching the pressure-sensitive adhesive sheet according to (1) above to the processed material;
   cutting the processed material to thereby form pieces of the processed material;
   expanding the pressure-sensitive adhesive sheet to thereby enlarge a gap between the pieces of the processed material attached to and fixed by the pressure-sensitive adhesive sheet; and
   separating the pieces of the processed material together with the pressure-sensitive adhesive layer attached thereto from the substrate.
(7) The method according to (6) above, wherein the processed material is a semiconductor device.
   In this regard, it is preferable that a semiconductor device is used as the processed material.
   Still furthermore, the present invention relates to the following (8).
(8) A piece of a processed material obtainable by the method according to (6) above.

The invention has the following advantages according to the above-mentioned means.

That is, according to the invention, by adding trialkyl phosphite as a thermal stabilizer to the substrate containing polyvinyl chloride as a primary component, the adhesive strength can be maintained for a long term even when the trialkyl phosphite is transferred into the pressure-sensitive adhesive layer and thus the pressure-sensitive adhesive sheet for dicing is excellent in long-term storage stability. Accordingly, since it is not necessary to form a barrier layer for preventing the transfer of the thermal stabilizer between the substrate and the pressure-sensitive adhesive layer, it is possible to prevent damage in flexibility on the pressure-sensitive adhesive sheet for dicing. As a result, since the step of forming the barrier layer is not necessary, it is possible to simplify the manufacturing processes and to reduce the manufacturing cost.

Hereinafter, an embodiment of the invention will be described with reference to Fig. 1. Fig. 1 is a sectional view schematically illustrating a pressure-sensitive adhesive sheet for dicing (hereinafter, referred to as pressure-sensitive adhesive sheet) according to an embodiment of the invention.

As shown in Fig. 1, pressure-sensitive adhesive sheet 10 has a structure in which a pressure-sensitive adhesive layer 12 and a separator 13 are sequentially laminated on a base film (substrate) 11.

The base film 11 serves as a support base for the pressure-sensitive adhesive layer 12 and the like and contains polyvinyl chloride as a primary component. The content of the polyvinyl chloride in the base film 11 is preferably 60 wt% or more, more preferably 70 wt% or more, and still more preferably 75 wt% or more.

Within a range in which the flexibility is not damaged, the base film 11 may contain low-density polyethylene, middle-density polyethylene, high-density polyethylene, polypropylene, polyester, polyvinyl chloride, ethylene-acetate vinyl copolymer, ethylene-(meth)acrylate copolymer, ethylene-(meth)acrylate ester copolymer, ionomer resin, ethylene-alpha olefin copolymer, or the like.

Trialkyl phosphite is added as a thermal stabilizer to the base film 11. Since the trialkyl phosphite does not contain an aryl group, it is compatible with poly(meth)acrylate ester. Accordingly, even when a small amount of trialkyl phosphite is transferred into the pressure-sensitive adhesive layer, it diffuses into the pressure-sensitive adhesive layer and does not unevenly distribute in the vicinity of the surface thereof. As a result, it is possible to suppress a marked deterioration in adhesive strength even when the pressure-sensitive adhesive sheet is stored for a long period of time.

As the trialkyl phosphite, it is preferable to use a compound represented by the following chemical structural formula: 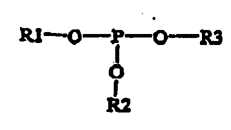 wherein R1, R2, and R3 are the same or different and each represent an alkyl having 8 to 13 carbon atoms.

In the chemical structural formula, by setting the number of carbons of the alkyl group to 8 to 13, the compatibility with the poly(meth)acxylate ester can be further enhanced.

The content of the trialkyl phosphite is preferably in a range of from 0.2 to 1 parts by weight with respect to 100 parts by weight of the polyvinyl chloride, more preferably in a range of from 0.3 to 0.7 parts by weight, and still more preferably in a range of from 0.3 to 0.5 parts by weight. When the content of the trialkyl phosphite is greater than 1 parts by weight, although the uneven distribution of the trialkyl phosphite transferred into the pressure-sensitive adhesive layer 12 in the vicinity of the surface of the pressure-sensitive adhesive layer 12 can be prevented, a large amount of trialkyl phosphite is contained in the whole pressure-sensitive adhesive layer 12, thereby deteriorating the long-term storage stability of the pressure-sensitive adhesive layer 12 in some cases. On the other hand, when the content is less than 0.2 parts by weight, vinyl chloride is thermally decomposed during shaping the base film 11, thereby generating toxic gas such as chlorine gas in some cases.

Furthermore, the base film 11 may contain alkylaryl phosphite in an amount less than 0.2 parts by weight with respect to 100 parts by weight of the polyvinyl chloride as a thermal stabilizer of the polyvinyl chloride. By adding the alkylaryl phosphite, it is possible to further enhance the stability of the trialkyl phosphite as a thermal stabilizer during shaping the substrate. When the content of the alkylaryl phosphite is 0.2 parts by weight or more with respect to 100 parts by weight of the polyvinyl chloride, the alkylaryl phosphite is transferred into the pressure-sensitive adhesive layer 12 and unevenly distributes in the vicinity of the surface thereof, thereby deteriorating the long-term storage stability of the pressure-sensitive adhesive layer 12 in some cases.

A variety of additives such as phthalate plasticizers such as dioctyl phthalate (DOP) and dibutyl phthalate (DBP), ester (polymer) plasticizers, plasticizers such as epoxy soybean oil, UV inhibitors, aliphatic or aromatic metal salts, bisphenol A, benzoates, and coloring agents may be mixed into the base film 11.

The base film 11 can be manufactured by the use of conventional methods such as a calendar roll shaping method. As the base film 11, a non-stretched film may be used, or a uniaxially- or biaxially-stretched film may be optionally used. Typical physical or chemical processes such as a matting process, a corona discharge process, a primer process, and a cross-linking process (chemical cross-linking (silane bonding)) may be performed to the surface thereof.

The thickness of the base film 11 is preferably in a range of from 50 to 200 µm and more preferably in a range of from 50 to 150 µm.

The pressure-sensitive adhesive layer 12 contains poly(meth)acrylic acid ester as a primary component. Typically, a polymer of (meth)acrylic acid alkyl ester or a copolymer thereof with a copolymerizable monomer is used as the poly(meth)acrylic acid ester. Alkyl (Meth)acrylate of which the glass transition temperature of the homopolymer is 20°C or less is preferably used as a main monomer of the polymer.

Examples of the alkyl group of the (meth)acrylic acid alkyl ester include a methyl group, an ethyl group, a butyl group, a 2-ethylhexyl group, an octyl group, and an isononyl group. Examples of the copolymerizable monomer include hydroxyalkyl ester of (meth)acrylic acid (such as hydroxyethyl ester, hydroxybutyl ester, and hydroxyhexyl ester), (meth)acrylic acid glycidyl ester, (meth)acrylic acid, itaconate, maleic anhydride, (meth)acrylic acid amide, (meth)acrylic acid N-hydroxymethyl amide, (meth)acrylic acid aminoalkyl (such as dimethyl aminoethyl methacrylate and t-butyl aminoethyl methacrylate), vinyl acetate, styrene, acrylonitrile, and acryloyl morphine.

Typical additives such as a cross-linking agent, a tackifier, a filler, an anti-aging agent, and a coloring agent can be optionally added to the adhesive. Examples of the cross-linking agent include poly isocyanate compounds, melamine resins, urea resins, aziridine compounds, epoxy resins, anhydrides, and polyamine carboxyl group-containing polymers.

The thickness of the pressure-sensitive adhesive layer 12 is preferably in a range of from 5 to 20 µm. When the thickness is less than 5 µm, the adhesive strength is decreased and a semiconductor wafer (processed material) cannot be reliably fixed during dicing. On the other hand, when the thickness is larger than 20 µm, the vibration occurring during dicing the semiconductor wafer is too large, thereby causing the chipping of the semiconductor chips (pieces of processed material).

In the invention, it is particularly preferable that the thickness of the base film 11 is in a range of 50 to 200 µm and the thickness of the pressure-sensitive adhesive layer 12 is in a range of 5 to 20 µm. For example, when the base film 11 and the pressure-sensitive adhesive layer 12 have substantially the same thickness and the trialkyl phosphite diffuses into the pressure-sensitive adhesive layer 12, the trialkyl phosphite in the base film 11 diffuses uniformly in the base film 11 and the pressure-sensitive adhesive layer 12. However, even in such a case, when the concentration of the trialkyl phosphite is initially high and the trialkyl phosphite diffuses into the pressure-sensitive adhesive layer 12, it is not possible to expect a great decrease in concentration in some cases. However, since the diffusion of the trialkyl phosphite into the pressure-sensitive adhesive layer 12 can be suppressed to the maximum by setting the thicknesses of the base film 11 and the pressure-sensitive adhesive layer 12 to the above-mentioned ranges, it is possible to further prevent the deterioration in long-term storage stability of the pressure-sensitive adhesive layer 12.

In the pressure-sensitive adhesive sheet 10 according to the invention, a separator 13 may be disposed on the pressure-sensitive adhesive layer 12 in order to perform a label process or to smooth the pressure-sensitive adhesive layer 12. The separator 13 can be made of a synthetic resin film of paper, polyethylene, polypropylene, polyethylene terephthalate, or the like. The surface of the separator 13 may be optionally subjected to a separation process such as a silicon treatment, a long-chain acryl treatment, or a fluorine treatment in order to enhance the separation property from the pressure-sensitive adhesive layer 12. Depending on the purposes for enhancing the rigidity and the like, the separator may be subjected to a uniaxial or biaxial stretching process or another plastic film may be laminated thereon. The thickness of the separator 13 is not particularly limited, but is preferably in a range of from 10 to 200 µm and more preferably in a range of from 25 to 100 µm.

Although the pressure-sensitive adhesive layer 12 is disposed on one surface of the base film 11 in Fig. 1, the pressure-sensitive adhesive layers 12 may be formed on both surfaces of the base film 11. The pressure-sensitive adhesive sheet 10 may have a tape shape in which the sheet is wound.

The pressure-sensitive adhesive sheet 10 according to the invention can be manufactured, for example, by applying and drying (heating and cross-linking according to the necessity) an adhesive onto the surface of the base film 11 to form the pressure-sensitive adhesive layer 12 and optionally attaching the separator 13 to the surface of the pressure-sensitive adhesive layer 12. Further, a method of forming the pressure-sensitive adhesive layer 12 on the separator 13 and then attaching them to the base film 11, or the like may be employed.

In the step of attaching the pressure-sensitive adhesive sheet 10 to a semiconductor wafer, the semiconductor wafer fixed to a support wafer (support plate) through a double-sided pressure-sensitive adhesive sheet is attached to the pressure-sensitive adhesive sheet 10 and the resultant structure is fixed to a dicing ring. The step is performed by superposing the semiconductor wafer and the pressure-sensitive adhesive sheet 10 with each other so that the pressure-sensitive adhesive layer 12 is positioned therebetween and then pressing them with pressing means such as a compressing roll. Further, attaching can also be performed by laminating the semiconductor wafer and the pressure-sensitive adhesive sheet 10 as described above in a pressurizable container (for example, an autoclave), and pressurizing the inside of the container. In this case, the pressure-sensitive adhesive sheet 10 may be attached onto the semiconductor wafer while pressing with the pressing means. Further, attaching can also be performed in a vacuum chamber in the same manner as described above. Although the attaching temperature in attaching step is not limited at all, it is preferably from 20 to 80°C.

The step of cutting (dicing) the semiconductor wafer to form semiconductor chips is performed from a circuit surface side of the semiconductor wafer by the use of a conventional method. Conventional methods such as a blade dicing method, a laser dicing method, a plasma dicing method, and a breaking method can be used as the dicing method. A dicing apparatus used in the process is not particularly limited and any conventional apparatus can be used.

In the step of separating the semiconductor chips, to which the pressure-sensitive adhesive layer 12 is attached, from the base film 11, for example, a method of pushing up the individual semiconductor chips from the pressure-sensitive adhesive sheet 10 side by the use of a needle and then picking up the pushed-up semiconductor chips by the use of a pickup apparatus or the like is performed.

In the following description, a case where a semiconductor wafer is used as the processed material is exemplified. However, the invention is not limited to the case, but may be applied to processed materials such as a semiconductor package, a glass, and a ceramics.

### Examples

Now, examples of the invention will be described in detail. However, the materials or the mixed amounts thereof described in the examples are not intended to limit the scope of the invention to the examples so long as there is no particularly restrictive description and are only explanatory examples.

### (Example 1)

### <Manufacturing of Base Film>

By forming a film (at a set temperature of 180°C) out of 100 parts by weight of polyvinyl chloride, 30 parts by weight of dioctyl phthalate (DOP), 0.55 parts by weight of barium stearate, 0.5 parts by weight of zinc stearate, and 0.6 parts by weight of tri-(octyl)-phosphite by the use of a calendar shaping apparatus, a base film formed of a polyvinyl chloride with a thickness of 100 µm was obtained.

### <Manufacturing of Pressure-sensitive adhesive sheet for dicing>

By copolymerizing 90 parts by weight of butyl acrylate and 10 parts by weight of acrylic acid in a toluene solution by the use of a known method, acrylic copolymer having a weight average molecular weight of 500,000 was obtained. By adding 5 parts by weight of a poly isocyanate compound (Trademark "Coronate L" manufactured by Nippon Polyurethane Industry Co., Ltd.) to a solution containing the acrylic copolymer, a UV-curable acrylic adhesive solution was prepared.

The prepared adhesive solution was applied onto a corona-treated surface of the manufactured base film and was heated and cross-linked at 80°C for 10 minutes to form a pressure-sensitive adhesive layer with a thickness of 10 µm. Subsequently, a separator was attached to the surface of the pressure-sensitive adhesive layer to manufacture a pressure-sensitive adhesive sheet for dicing.

### (Example 2)

### <Manufacturing of Base Film>

In this embodiment, by using the same way as Example 1 except that tri-(tridecyl)-phosphite is used instead of tri-(octyl)-phosphite, a base film according to this example was manufactured.

### <Manufacturing of Pressure-sensitive adhesive sheet for dicing>

The adhesive solution prepared in Example 1 was applied onto the manufactured base film and was heated and cross-linked at 80°C for 10 minutes to form a UV-curable pressure-sensitive adhesive layer with a thickness of 10 µm. Subsequently, a separator was attached to the surface of the pressure-sensitive adhesive layer to manufacture a pressure-sensitive adhesive sheet for dicing.

### (Comparative Example 1)

### <Manufacturing of Base Film>

In this comparative example, by using the same way as Example 1 except that monodecyl-diaryl phosphite is used instead of tri-(octyl)-phosphite, a base film according to this comparative example was manufactured.

### <Manufacturing of Pressure-sensitive adhesive sheet for dicing>

The adhesive solution prepared in Example 1 was applied onto the manufactured base film and was heated and cross-linked at 80°C for 10 minutes to form a UV-curable pressure-sensitive adhesive layer with a thickness of 10 µm. Subsequently, a separator was attached to the surface of the pressure-sensitive adhesive layer to manufacture a pressure-sensitive adhesive sheet for dicing.

### (Comparative Example 2)

### <Manufacturing of Base Film>

In this comparative example, by using the same way as Example 1 except that didecyl-monoaryl phosphite is used instead of tri-(octyl)-phosphite, a base film according to this comparative example was manufactured.

### <Manufacturing of Pressure-sensitive adhesive sheet for dicing>

The adhesive solution prepared in Example 1 was applied onto the manufactured base film and was heated and cross-linked at 80°C for 10 minutes to form a UV-curable pressure-sensitive adhesive layer with a thickness of 10 µm. Subsequently, a separator was attached to the surface of the pressure-sensitive adhesive layer to manufacture a pressure-sensitive adhesive sheet for dicing.

### (Comparative Example 3)

### <Manufacturing of Base Film>

In this comparative example, by using the same way as Example 1 except that triaryl phosphite is used instead of tri-(octyl)-phosphite, a base film according to this comparative example was manufactured.

### <Manufacturing of Pressure-sensitive adhesive sheet for dicing>

The adhesive solution prepared in Example 1 was applied onto the manufactured base film and was heated and cross-linked at 80°C for 10 minutes to form a UV-curable pressure-sensitive adhesive layer with a thickness of 10 µm. Subsequently, a separator was attached to the surface of the pressure-sensitive adhesive layer to manufacture a pressure-sensitive adhesive sheet for dicing.

### (Reference Example 1)

### <Manufacturing of Base Film>

In this reference example, by using the same way as Example 1 except that the content of the tri-(octyl)-phosphite is changed to 1.5 parts by weight, a base film according to this reference example was manufactured.

### <Manufacturing of Pressure-sensitive adhesive sheet for dicing>

The adhesive solution prepared in Example 1 was applied onto the manufactured base film and was heated and cross-linked at 80°C for 10 minutes to form a UV-curable pressure-sensitive adhesive layer with a thickness of 10 µm. Subsequently, a separator was attached to the surface of the pressure-sensitive adhesive layer to manufacture a pressure-sensitive adhesive sheet for dicing.

### (Test)

The pressure-sensitive adhesive sheets for dicing obtained in the examples, the comparative examples, and the reference example were stored at a room temperature for 0 day (initial), 7 days, 14 days, 30 days, 60 days, and 90 days and then adhesive strength thereof was measured under the following conditions.

Measurement Environment: 20°C, 50%RH

Adherend: Silicon Mirror Wafer (manufactured by Shinetsu Handotai Co. Ltd.)

Measurement Apparatus: Universal Tension and Compression Tester (manufactured by Orientec Co., Ltd.)

Sample Piece Width: 20 mm

Sample Piece Pressing Apparatus: 2 kg roller

Left Time after Test Attachment: 30 minutes

Separation Angle: 90°

Stretching Speed: 300 mm/min

As can be seen from Table 1, the pressure-sensitive adhesive sheets for dicing according to Examples 1 and 2 showed a small deterioration in adhesive strength due to storage of the adhesive sheet and showed stable adhesive strength after 14 days or 30 days has passed since they were manufactured. On the other hand, in the pressure-sensitive adhesive sheets for dicing according to Comparative Example 1 to 3, the deterioration in adhesive strength was great and the adhesive strength deteriorated continuously even after 60 days has passed since they were manufactured. As a result, the pressure-sensitive adhesive sheets for dicing according to Examples 1 and 2 can be stably used even after 14 days from the manufacture thereof. On the contrary, the pressure-sensitive adhesive sheets for dicing according to Comparative Examples 1 to 3 are not stable after a month or more from the manufacture thereof. Accordingly, when the pressure-sensitive adhesive sheets for dicing according to the comparative examples are used, it is considered that the scattering of chips occurs during dicing. In the pressure-sensitive adhesive sheet for dicing according to Reference Example 1, the deterioration in adhesive strength was observed until 30 days after it is manufactured, but the adhesive strength was stable after 60 days from the manufacture thereof.

**Table 1**

| | Adhesive Strength of Pressure-sensitive adhesive sheet for dicing [N/20 mm] | | | | | |
|---|---|---|---|---|---|---|
| | 0 days | 7 days | 14 days | 30 days | 60 days | 90 days |
| Example 1 | 1.5 | 1.2 | 1.1 | 1.1 | 1.1 | 1.1 |
| Example 2 | 1.5 | 1.2 | 1.1 | 1.0 | 1.0 | 1.0 |
| Comparative Example 1 | 1.4 | 1.1 | 1.0 | 0.9 | 0.8 | 0.7 |
| Comparative Example 2 | 1.4 | 1.1 | 1.0 | 0.9 | 0.8 | 0.7 |
| Comparative Example 3 | 1.3 | 0.9 | 0.7 | 0.6 | 0.6 | 0.5 |
| Reference Example 1 | 1.5 | 1.1 | 1.0 | 0.9 | 0.8 | 0.8 |

While the present invention has been described in detail and with reference to specific embodiments thereof, it will be apparent to one skilled in the art that various changes and modifications can be made therein without departing from the scope thereof.

This application is based on Japanese patent application No. 2006-154736 filed June 2, 2006, the entire contents thereof being hereby incorporated by reference.

Further, all references cited herein are incorporated in their entireties.

## Claims

1. A pressure-sensitive adhesive sheet for dicing, which comprises a substrate and at least one pressure-sensitive adhesive layer disposed on at least one surface of the substrate,
said substrate containing polyvinyl chloride as a primary component and a trialkyl phosphite as a thermal stabilizer of the polyvinyl chloride, and
said pressure-sensitive adhesive layer containing poly(meth)acrylic acid ester as a primary component, wherein the trialkyl phosphite transferred from the substrate into the pressure-sensitive adhesive layer is not unevenly distributed on a surface of the pressure-sensitive adhesive layer.

2. The pressure-sensitive adhesive sheet according to claim 1, wherein the trialkyl phosphite is contained in an amount of from 0.2 to 1 parts by weight with respect to 100 parts by weight of the polyvinyl chloride.

3. The pressure-sensitive adhesive sheet according to claim 1, wherein the trialkyl phosphite is a compound represented by the following chemical structural formula: 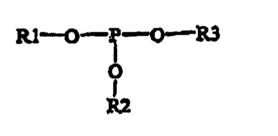 wherein R1, R2, and R3 are the same or different and each represent an alkyl group having 8 to 13 carbon atoms.

4. The pressure-sensitive adhesive sheet according to claim 1, wherein the substrate has a thickness of from 50 to 200 µm and the pressure-sensitive adhesive layer has a thickness of from 5 to 20 µm.

5. The pressure-sensitive adhesive sheet according to claim 1, which further comprises, as a thermal stabilizer of the polyvinyl chloride, an alkylaryl phosphite in an amount of less than 0.2 parts by weight with respect to 100 parts by weight of the polyvinyl chloride.

6. A method of processing a processed material, which comprises:
attaching the pressure-sensitive adhesive sheet according to claim 1 to the processed material;
cutting the processed material to thereby form pieces of the processed material;
expanding the pressure-sensitive adhesive sheet to thereby enlarge a gap between the pieces of the processed material attached to and fixed by the pressure-sensitive adhesive sheet; and
separating the pieces of the processed material together with the pressure-sensitive adhesive layer attached thereto from the substrate.

7. The method according to claim 6, wherein the processed material is a semiconductor device.

8. A piece of a processed material obtainable by the method according to claim 6.

## Patentansprüche

1. Haftklebefolie zum Zerschneiden, welche ein Substrat und wenigstens eine Haftklebstoffschicht, die auf wenigstens einer Oberfläche des Substrats aufgebracht ist, umfasst,
wobei das Substrat Polyvinylchlorid als einen Hauptbestandteil und ein Trialkylphosphit als einen Wärmestabilisator des Polyvinylchlorids enthält, und
wobei die Haftklebstoffschicht Poly(meth)acrylsäureester als einen Hauptbestandteil enthält, wobei das aus dem Substrat in die Haftklebstoffschicht überführte Trialkylphosphit nicht ungleichmäßig auf einer Oberfläche der Haftklebstoffschicht verteilt ist.

2. Haftklebefolie nach Anspruch 1, wobei das Trialkylphosphit in einer Menge von 0,2 bis 1 Gewichtsteilen, bezogen auf 100 Gewichtsteile des Polyvinylchlorids, enthalten ist.

3. Haftklebefolie nach Anspruch 1, wobei das Trialkylphosphit eine Verbindung ist, die durch die folgende chemische Strukturformel wiedergegeben ist: 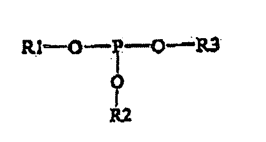 worin R1, R2 und R3 gleich oder verschieden sind und jeweils eine Alkylgruppe mit 8 bis 13 Kohlenstoffatomen bedeuten.

4. Haftklebefolie nach Anspruch 1, wobei das Substrat eine Dicke von 50 bis 200 µm aufweist und die Haftklebstoffschicht eine Dicke von 5 bis 20 µm aufweist.

5. Haftklebefolie nach Anspruch 1, welche außerdem als einen Wärmestabilisator des Polyvinylchlorids ein Alkylarylphosphit in einer Menge von weniger als 0,2 Gewichtsteilen, bezogen auf 100 Gewichtsteile des Polyvinylchlorids, umfasst.

6. Verfahren zum Verarbeiten eines verarbeiteten Materials, welches umfasst:
das Anbringen der Haftklebefolie nach Anspruch 1 an dem verarbeiteten Material;
das Schneiden des verarbeiteten Materials, um dadurch Stücke des verarbeiteten Materials zu bilden;
das Ausdehnen der Haftklebefolie, um dadurch einen Spalt zwischen den Stücken des verarbeiteten Materials zu vergrößern, die an der Haftklebefolie angebracht und durch sie fixiert sind; und
das Trennen der Stücke des verarbeiteten Materials zusammen mit der daran angebrachten Haftklebstoffschicht von dem Substrat.

7. Verfahren nach Anspruch 6, wobei das verarbeitete Material eine Halbleitervorrichtung ist.

8. Stück eines verarbeiteten Materials, das durch das Verfahren nach Anspruch 6 erhältlich ist.

## Revendications

1. Feuille adhésive autocollante pour découper des puces, qui comprend un support et au moins une couche adhésive autocollante disposée sur au moins une surface du support,
ledit support contenant du chlorure de polyvinyle comme composant principal, et un trialkyl phosphite comme stabilisant thermique du chlorure de polyvinyle, et
ladite couche adhésive autocollante contenant un ester d'acide poly(méth)acrylique comme composant principal, le trialkyl phosphite transféré du support dans la couche adhésive autocollante n'étant pas distribué non-uniformément sur une surface de la couche adhésive autocollante.

2. Feuille adhésive autocollante selon la revendication 1, dans laquelle le trialkyl phosphite est contenu en quantité de 0,2 à 1 partie en poids pour 100 parties en poids du chlorure de polyvinyle.

3. Feuille adhésive autocollante selon la revendication 1, dans laquelle le trialkyl phosphite est un composé représenté par la formule de structure chimique qui suit : 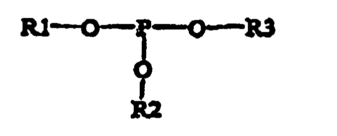 dans laquelle R1, R2 et R3 sont identiques ou différents, et représentent chacun un groupement alkyle comptant 8 à 13 atomes de carbone.

4. Feuille adhésive autocollante selon la revendication 1, dans laquelle le support a une épaisseur de 50 à 200 µm, et la couche adhésive autocollante a une épaisseur de 5 à 20 µm.

5. Feuille adhésive autocollante selon la revendication 1, qui comprend de plus, comme stabilisant thermique du chlorure de polyvinyle, un alkylaryl phosphite en quantité inférieure à 0,2 partie en poids pour 100 parties en poids du chlorure de polyvinyle.

6. Procédé de traitement d'une matière manufacturée, qui comprend les étapes consistant à :
attacher la feuille adhésive autocollante selon la revendication 1 à la matière manufacturée,
découper la matière manufacturée pour ainsi former des morceaux de la matière manufacturée,
expanser la feuille adhésive autocollante pour ainsi agrandir l'espace entre les morceaux de la matière manufacturée attachés à, et fixés par la feuille adhésive autocollante, et
séparer du support les morceaux de la matière manufacturée en même temps que la couche adhésive autocollante qui y est attachée.

7. Procédé selon la revendication 6, dans lequel la matière manufacturée est un dispositif semi-conducteur.

8. Morceau d'une matière manufacturée pouvant être obtenu par le procédé de la revendication 6.
